# EUROPÄISCHE PATENTSCHRIFT

(11) **EP 3 794 361 B1**
(45) Veröffentlichungstag und Bekanntmachung des Hinweises auf die Patenterteilung: **12.07.2023**
(21) Anmeldenummer: 19725951.8
(22) Anmeldetag: 15.05.2019
(51) Int. Cl.: G01H 3/00, G01H 1/00, G01R 31/00

(54) **ZUSTANDSANALYSE EINES INDUKTIVEN BETRIEBSMITTELS**
STATE ANALYSIS OF AN INDUCTIVE OPERATING RESOURCE
ANALYSE D'ÉTAT D'UN ÉQUIPEMENT À INDUCTION

(30) Priorität: 18.05.2018 DE 102018112003
(43) Veröffentlichungstag der Anmeldung: 24.03.2021
(73) Patentinhaber: Maschinenfabrik Reinhausen GmbH, 93059 Regensburg (DE)
(72) Erfinder: VIERECK, Karsten, 93049 Regensburg (DE); SAVELIEV, Anatoli, 93197 Zeitlarn (DE)
(86) Internationale Anmeldenummer: PCT/EP2019/062514
(87) Internationale Veröffentlichungsnummer: WO 2019/219761

(56) Entgegenhaltungen:
- EP-A1- 1 786 083
- WO-A1-2016/168621
- US-A1- 2014 174 185
- US-B1- 6 507 790
- US-B2- 7 567 878
- B. GARCIA ET AL: "Transformer Tank Vibration Modeling as a Method of Detecting Winding Deformations-Part II: Experimental Verification", IEEE TRANSACTIONS ON POWER DELIVERY., Bd. 21, Nr. 1, 27. Dezember 2005 (2005-12-27), Seiten 164-169, XP055546052, US ISSN: 0885-8977, DOI: 10.1109/TPWRD.2005.852275
- KANG P ET AL: "NON-INVASIVE ON-LINE CONDITION MONITORING OF ON LOAD TAP CHANGERS", 2000 IEEE POWER ENGINEERING SOCIETY. WINTER MEETING. CONFERENCE PROCEEDINGS. SINGAPORE, JAN. 23-27, 2000; [IEEE POWER ENGINEERING SOCIETY WINTER MEETING], NEW YORK, NY : IEEE, US, 23 January 2000 (2000-01-23), pages 2223-2228, XP000967815, ISBN: 978-0-7803-5936-9

## Beschreibung

Die Erfindung betrifft ein Verfahren zur Zustandsanalyse eines induktiven Betriebsmittels sowie ein System zur Zustandsanalyse eines induktiven Betriebsmittels und ein induktives Betriebsmittel mit einem solchen System.

Zur Analyse des Zustands eines induktiven Betriebsmittels, wie zum Beispiel eines Leistungstransformators in einem Energieversorgungsnetz oder einer Drossel, ist es bisher mitunter erforderlich, Messungen oder Überprüfungen direkt am Aktivteil des induktiven Betriebsmittels durchzuführen. Dazu kann beispielsweise die Spannkraft der Wicklungen geprüft werden, was in der Regel sehr aufwändig ist, da sich das Betriebsmittel typischerweise in einem mit Isolierstoff gefüllten Kessel befindet. Zudem muss das Betriebsmittel für die Prüfung vom Netz genommen werden. Auch komplexe Messungen wie eine dynamische Widerstandsmessung oder eine Frequenzantwort-Analyse, FRA, sind zum einen aufwändig und erfordern ebenfalls eine Trennung des Betriebsmittels vom Netz. Der Stand der Technik wird beschrieben in den Dokumenten US 2014/174185, EP 1 786 083, US 7 567 878, B. GARCIA ET AL: "Transformer Tank Vibration Modeling as a Method of Detecting Winding Deformations-Part II: Experimental Verification",IEEE TRANSACTIONS ON POWER DELIVERY., Bd. 21, Nr. 1, 27. Dezember 2005 (2005-12-27), Seiten 164-169 und Kang, P. ETAL, 23.01.2000, Non-invasive on-line condition monitoring of on load tap changers, Power Engineering society winter meeting, 23-27.01.2000.

Es ist daher eine Aufgabe der vorliegenden Erfindung ein verbessertes Konzept für die Zustandsanalyse eines Transformators oder einer Drossel anzugeben, welches die Zustandsanalyse vereinfacht.

Diese Aufgabe wird durch den Gegenstand der unabhängigen Ansprüche gelöst. Weitere Ausführungsformen sind Gegenstand der abhängigen Ansprüche.

Das verbesserte Konzept beruht auf der Idee, ein akustisches Referenzsignal sowie zeitlich veränderliche Betriebsgrößen eines Betriebsmittels, welches als Transformator oder Drossel ausgebildet ist, während eines Referenzzeitraums aufzuzeichnen und daraus ein Regressionsmodell zu erstellen, welches das akustische Referenzsignal durch die Betriebsgrößen als unabhängige Variablen beschreibt. Während des Produktivbetriebs werden wiederum ein akustisches Signal und die Betriebsgrößen aufgezeichnet. Der Zustand des Betriebsmittels wird dann anhand einer Abweichung eines Produktivdatensatzes von modellierten Werten bewertet.

Gemäß dem verbesserten Konzept wird ein Verfahren zur Zustandsanalyse eines induktiven Betriebsmittels, welches als Transformator oder Drossel ausgebildet ist, angegeben. Dabei werden ein akustisches Referenzsignal und eine Mehrzahl zeitlich veränderlicher Betriebsgrößen des Betriebsmittels oder eines Referenzbetriebsmittels während eines Referenzzeitraums erfasst. Das Referenzbetriebsmittel kann beispielsweise baugleich zu dem Betriebsmittel sein. Aus dem Referenzsignal wird ein Referenzdatensatz erzeugt. Basierend auf dem Referenzdatensatz wird eine Regressionsanalyse durchgeführt und daraus ein Modell zur Beschreibung des akustischen Referenzsignals durch die Betriebsgrößen erstellt. Während eines Produktivzeitraums werden ein akustisches Signal, also ein akustisches Produktivsignal, und die Betriebsgrößen erfasst. Aus dem während des Produktivzeitraums erfassten akustischen Signal wird ein Produktivdatensatz erzeugt. Es wird dann eine Abweichung zwischen dem Produktivdatensatz und denjenigen Werten, welche sich dem Modell zufolge ergeben, bestimmt. Aus der Abweichung wird eine Zustandsbewertung durchgeführt.

Insbesondere repräsentiert die Abweichung eine Differenz eines Referenz- oder Sollzustands des Betriebsmittels von dem tatsächlichen Zustand des Betriebsmittels während des Produktivzeitraums.

Während des Referenzzeitraums sowie während des Produktivzeitraums sind das Betriebsmittel beziehungsweise das Referenzbetriebsmittel im Betrieb.

Der Produktivzeitraum und der Referenzzeitraum können in verschiedenen Ausführungsformen überlappen. Insbesondere kann der Referenzzeitraum auch ein produktiver Betriebszeitraum des Betriebsmittels oder Referenzbetriebsmittels sein.

Gemäß zumindest einer Ausführungsform entspricht der Zustand des Referenzbetriebsmittels beziehungsweise des Betriebsmittels während dem Referenzzeitraum einem Sollzustand. Der Sollzustand kann beispielsweise einem Zustand kurz nach einer Wartung oder kurz nach der ursprünglichen Herstellung des Referenzbetriebsmittels oder des Betriebsmittels entsprechen.

Gemäß zumindest einer Ausführungsform erfolgt die Regressionsanalyse unter Verwendung der Betriebsgrößen als unabhängige Regressionsvariablen.

Gemäß zumindest einer Ausführungsform werden die Werte, welche sich dem Modell zufolge ergeben, also die gemäß dem Modell modellierten Werte, auf Grundlage der während des Produktivzeitraums erfassten Betriebsgrößen bestimmt.

Gemäß zumindest einer Ausführungsform umfasst das Verfahren das Erfassen mindestens eines weiteren akustischen Signals und der Betriebsgrößen während mindestens eines weiteren Produktivzeitraums. Aus dem mindestens einen weiteren akustischen Signal wird mindestens ein weiterer Produktivdatensatz erzeugt. Mindestens eine weitere Zustandsbewertung des Betriebsmittels wird aus entsprechenden Abweichungen zwischen dem mindestens einen weiteren Produktivdatensatz und gemäß dem Modell modellierten Werten erzeugt.

Gemäß zumindest einer Ausführungsform umfasst das Verfahren die Bestimmung eines Zustandstrends des Betriebsmittels aus der Zustandsbewertung und der mindestens einen weiteren Zustandsbewertung.

Gemäß zumindest einer Ausführungsform wird der Referenzdatensatz auf Grundlage des Produktivdatensatzes und/oder des mindestens einen weiteren Produktivdatensatzes aktualisiert. Das Modell wird mittels Regressionsanalyse des aktualisierten Referenzdatensatzes aktualisiert.

Gemäß zumindest einer Ausführungsform umfasst das Verfahren das Vorschlagen und/oder Vornehmen einer Handlung an dem Betriebsmittel in Abhängigkeit von der Zustandsbewertung und/oder der mindestens einen weiteren Zustandsbewertung und/oder dem Zustandstrend.

Die Handlung kann beispielsweise eine Wartung, Überprüfung, Markierung oder Stilllegung des Betriebsmittels umfassen. Die Handlung kann es beispielsweise umfassen, das Betriebsmittel von einem Energieversorgungsnetz zu trennen, beispielsweise automatisch. Die Handlung kann beispielsweise eine zusätzliche, insbesondere detaillierte, Messung, beispielsweise direkt am Aktivteil, umfassen.

Mittels des Verfahrens wird es also ermöglicht, eine Zustandsbewertung des Betriebsmittels ohne komplexe und aufwändige, physische Messungen direkt am Aktivteil des Betriebsmittels durchzuführen. Vorteilhafterweise werden die Betriebsgrößen des Betriebsmittels beispielsweise im Rahmen einer routinemäßigen Überwachung des Betriebsmittels erfasst. Die zusätzliche Information über das akustische Signal und deren Verarbeitung unter Einbezug der Betriebsgrößen erlaubt daher eine kontinuierliche und einfache Bewertung des Zustands.

Gemäß zumindest einer Ausführungsform erfolgt das Erfassen des akustischen Signals und/oder des akustischen Referenzsignals mittels eines Schallwandlers oder eines Beschleunigungssensors. Der Schallwandler oder Beschleunigungssensor ist dabei am Betriebsmittel oder im Inneren des Betriebsmittels oder an einem Aktivteil des Betriebsmittels angeordnet. In Ausführungsformen, in denen ein Referenzbetriebsmittel eingesetzt wird, ist der Schallwandler zum Erfassen des Referenzsignals am Betriebsmittel oder im Inneren des Betriebsmittels oder an einem Aktivteil des Betriebsmittels angeordnet.

Gemäß zumindest einer Ausführungsform ist der Schallwandler oder Beschleunigungssensor ein elektromagnetischer, piezoelektrischer oder piezoresistiver Schallwandler und/oder ein mikro-elektro-mechanischer Sensor, MEMS.

Gemäß zumindest einer Ausführungsform umfasst das Erzeugen des Produktivdatensatzes die Bestimmung eines charakteristischen Datensatzes. Der charakteristische Datensatz entspricht dem zeitlichen Verlauf einer Amplitude eines vorbestimmten Frequenzanteils des akustischen Signals. Analoges gilt für den Referenzdatensatz. Die vorbestimmten Frequenzanteile können beispielsweise zu erwartenden Resonanzen oder Polstellen entsprechen, oder Vielfachen davon.

Gemäß zumindest einer Ausführungsform erfolgt das Erfassen der Betriebsgrößen mittels wenigstens eines Sensors und/oder wenigstens einer Überwachungseinrichtung oder Monitoring-Einrichtung.

Gemäß der Erfindung umfasst die Betriebsgröße eine Stufenschalterstellung des Betriebsmittels oder des Referenzbetriebsmittels. Gemäß zumindest einer Ausführungsform umfassen die Betriebsgrößen zusätzlich wenigstens eine der folgenden Größen des Betriebsmittels beziehungsweise des Referenzbetriebsmittels: Eine Isoliermitteltemperatur, eine Öltemperatur, eine Hot-Spot Temperatur, eine Wicklungstemperatur, eine Umgebungstemperatur, ein Laststrom, eine Betriebsspannung. Vorzugsweise umfassen die Betriebsgrößen mehrere der genannten Grö-ßen. Dadurch kann eine höhere Genauigkeit des Modells erreicht werden.

Gemäß zumindest einer Ausführungsform umfasst die Regressionsanalyse eine lineare Regressionsanalyse, insbesondere eine multiple lineare Regressionsanalyse. In diesem Fall geht der Referenzdatensatz aus einer Linearkombination der Betriebsgrößen hervor.

Gemäß der Erfindung umfasst das Betriebsmittel einen Transformator, insbesondere einen Leistungstransformator, oder eine Drossel, beispielsweise eine regelbare Drossel, insbesondere einen Variable Shunt Reactor, VSR. Der Transformator oder die Drossel können beispielsweise Teil eines Energieversorgungsnetzes sein.

Gemäß der Erfindung wird außerdem ein System zur Zustandsanalyse eines induktiven Betriebsmittels angegeben, wobei das Betriebsmittel als Transformator oder Drossel ausgebildet ist. Das System umfasst eine Messeinrichtung und eine Auswerteeinrichtung. Die Messeinrichtung ist dazu eingerichtet, ein akustisches Referenzsignal und eine Mehrzahl zeitlich veränderlicher Betriebsgrößen des Betriebsmittels oder eines Referenzbetriebsmittels während eines Referenzzeitraums zu erfassen. Außerdem ist die Messeinrichtung dazu eingerichtet, ein akustisches Signal und die Betriebsgrößen während eines Produktivzeitraums zu erfassen. Die Auswerteeinrichtung ist dazu eingerichtet, einen Referenzdatensatz aus dem Referenzsignal und einen Produktivdatensatz aus dem akustischen Signal zu erzeugen und eine Regressionsanalyse des Referenzdatensatzes durchzuführen. Die Auswerteeinheit ist dazu eingerichtet, mittels der Regressionsanalyse ein Modell zur Beschreibung des akustischen Referenzsignals durch die Betriebsgrößen zu erstellen und eine Zustandsbewertung des Betriebsmittels aus einer Abweichung zwischen dem Produktivdatensatz und gemäß dem Modell modellierten Werten zu erzeugen.

Gemäß zumindest einer Ausführungsform umfasst die Messeinrichtung zum Erfassen des akustischen Signals einen Schallwandler oder einen Beschleunigungssensor, welcher am Betriebsmittel oder im Inneren des Betriebsmittels oder an einem Aktivteil des Betriebsmittels angeordnet ist.

Gemäß zumindest einer Ausführungsform umfasst die Messeinrichtung zum Erfassen der Betriebsgrößen wenigstens einen Sensor und/oder wenigstens eine Überwachungseinrichtung.

Gemäß dem verbesserten Konzept wird außerdem ein induktives Betriebsmittel angegeben, insbesondere ein Transformator oder eine Drossel, welches ein System zur Zustandsanalyse gemäß dem verbesserten Konzept umfasst.

Weitere Ausgestaltungsformen und Implementierungen des Systems und des induktiven Betriebsmittels ergeben sich unmittelbar aus den verschiedenen Ausgestaltungsformen des Verfahrens.

Im Folgenden wird die Erfindung anhand beispielhafter Ausführungsformen unter Bezug auf die Zeichnungen erklärt.

### Es zeigen

- Figur 1: ein Blockdiagramm eines Betriebsmittels mit einem beispielhaften System nach dem verbesserten Konzept; und
- Figuren 2A, 2B: Datensätze erhalten aus einem beispielhaften Verfahrens nach dem verbesserten Konzept.

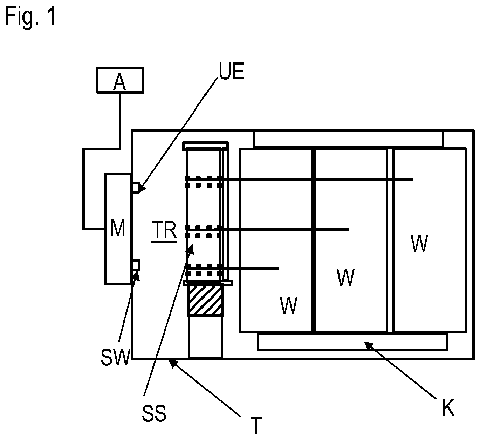

Figur 1 zeigt ein induktives Betriebsmittel, welches hier lediglich exemplarisch als Transformator TR, insbesondere Leistungstransformator ausgebildet und mit einem System zur Zustandsanalyse des Betriebsmittels gemäß dem verbesserten Konzept ausgestattet ist.

Der Transformator TR umfasst einen Tank oder Kessel T, der beispielsweise mit einem Isoliermittel, insbesondere einer Isolierflüssigkeit, zum Beispiel Transformatoröl, gefüllt ist. Im Inneren des Tanks T ist der Aktivteil des Transformators TR angeordnet, insbesondere der Transformatorkern K sowie Transformatorwicklungen W. Außerdem befindet sich im Inneren des Tanks T zum Beispiel ein Stufenschalter SS zum Umschalten zwischen verschiedenen Wicklungsanzapfungen.

Das System zur Zustandsanalyse umfasst eine Messeinrichtung M, welche beispielsweise einen Schallwandler SW sowie einen Sensor UE. Das System weist außerdem eine Auswerteeinrichtung A auf, welche kabelgebunden oder kabellos mit der Messeinrichtung M verbunden ist. Die Auswerteinrichtung A kann am Transformator TR oder entfernt vom Transformator TR angeordnet sein. Teile der Messeinrichtung M können ebenfalls am Transformator TR oder entfernt davon angeordnet sein.

Der Schallwandler SW ist beispielsweise an einer Außenfläche des Tanks T angeordnet. In alternativen Ausführungsformen kann es erforderlich sein, dass der Schallwandler SW innerhalb des Tanks T angeordnet ist. Der Sensor UE ist je nach Art des Sensors UE oder der damit erfassbaren Betriebsgröße entweder innerhalb des Tanks T (zum Beispiel bei der Messung einer Wicklungstemperatur oder einer Öltemperatur) oder außerhalb des Tanks (zum Beispiel bei der Messung einer Betriebsspannung oder einer Umgebungstemperatur) angeordnet.

Die Messeinrichtung M kann alternativ oder zusätzlich zum Schallwandler SW einen Beschleunigungssensor und alternativ oder zusätzlich zum Sensor UE eine Überwachungsbeziehungsweise Monitoringeinrichtung beinhalten.

Im Rahmen eines Verfahrens gemäß dem verbesserten Konzept erfasst der Schallwandler SW oder Beschleunigungssensor während eines Referenzzeitraums ein akustisches Referenzsignal, welches ein Abbild des Betriebsgeräusches des Transformators TR darstellt.

Parallel dazu erfasst der Sensor UE oder die Überwachungseinrichtung eine oder mehrere Betriebsgrößen des Transformators TR als Funktion der Zeit, beispielsweise Isoliermitteltemperatur, Umgebungstemperatur, Laststrom, Betriebsspannung, Stellung des Stufenschalters SS und/oder weitere Betriebsparameter.

Die Auswerteeinrichtung A erzeugt aus dem Referenzsignal einen Referenzdatensatz und führt eine Regressionsanalyse des Referenzdatensatz durch. Basierend darauf wird ein Modell zur Beschreibung des akustischen Referenzsignals durch die Betriebsgrößen erstellt.

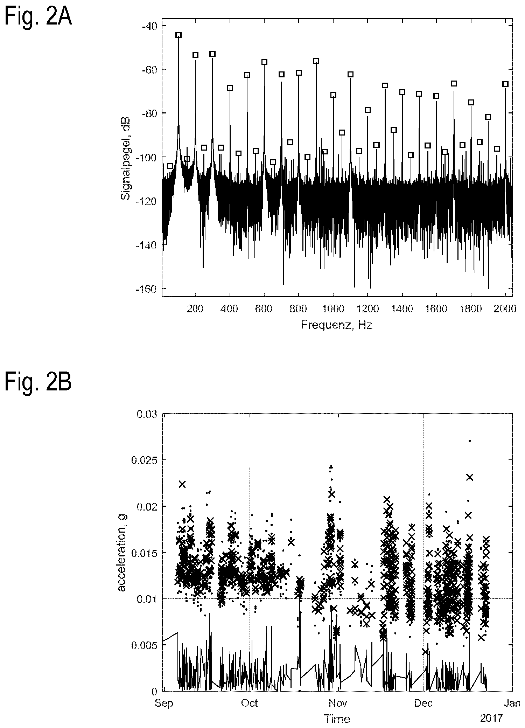

Während eines Produktivzeitraums, der nach dem Referenzzeitraum liegt, erfasst der Schallwandler SW oder Beschleunigungssensor ein akustisches Produktivsignal, welches ebenfalls ein Abbild des Betriebsgeräusches des Transformators TR, jedoch zu einem späteren Zeitpunkt darstellt. In Figur 2A ist beispielhaft ein Frequenzspektrum des Betriebsgeräusches eines Betriebsmittels gezeigt.

Parallel dazu erfasst der Sensor UE oder die Überwachungseinrichtung diejenigen Betriebsgrößen, die auch während des Referenzzeitraums erfasst wurden oder einen Teil davon.

Die Auswerteeinrichtung erzeugt einen Referenzdatensatz aus dem Referenzsignal und einen Produktivdatensatz aus dem akustischen Signal. Dazu wird beispielsweise die vom Sensor UE gemessene physikalische Größe (beispielsweise Beschleunigung g) oder eine davon abgeleitete Größe als Funktion der Zeit für eine charakteristische Frequenz oder einen charakteristischen Frequenzbereich ermittelt. Figur 2B zeigt hierzu beispielhaft die von einem Beschleunigungssensor gemessene Beschleunigung in einem Frequenzbereich um 200 Hz (Punkte in Fig. 2B).

Dann wird eine Abweichung (durchgezogene Linie in Figur 2B) zwischen dem Produktivdatensatz und den entsprechenden gemäß dem Modell berechneten Werten bestimmt (Punkte in Figur 2B). Die Abweichung ist dann als Maß für den Zustand des Betriebsmittels zu betrachten.

Optional kann das System abhängig von einer Bewertung des Zustands eine Handlung vorschlagen oder einleiten, beispielsweise die Wartung des Betriebsmittels oder die Trennung des Betriebsmittels vom Netz.

Zur Verbesserung der Zustandsbewertung kann die Abweichung optional auch für mehrere charakteristische Frequenzen oder Frequenzbereich durchgeführt werden.

Das Referenzsignal und/oder das Produktivsignal können beispielsweise von der Messeinrichtung M oder der Auswerteeinrichtung A gespeichert werden, zum Beispiel im Wave-Dateiformat.

Optional können auch mehrere Schallwandler oder Beschleunigungssensoren zum Erfassen der akustischen Signale eingesetzt werden, um die Genauigkeit und Aussagekraft des Verfahrens zu verbessern.

Zudem kann es vorteilhaft sein möglichst viele verschieden Betriebsgrößen des Betriebsmittels zu erfassen und in die Regressionsanalyse einzubeziehen, um deren Genauigkeit zu verbessern.

### BEZUGSZEICHEN

- TR: Betriebsmittel
- T: Tank
- K: Kern
- W: Wicklungen
- SS: Stufenschalter
- A: Auswerteeinrichtung
- M: Messeinrichtung
- SW: Schallwandler oder Beschleunigungssensor
- UE: Sensor oder Überwachungseinrichtung

## Patentansprüche

1. System zur Zustandsanalyse eines induktiven Betriebsmittels, das als Transformator oder Drossel ausgebildet ist, das System umfassend
- eine Messeinrichtung (M), dazu ausgebildet
- ein akustisches Referenzsignal und eine Mehrzahl zeitlich veränderlicher Betriebsgrößen des Betriebsmittels (TR) oder eines Referenzbetriebsmittels während eines Referenzzeitraums zu erfassen; und
- ein akustisches Signal und die Betriebsgrößen während eines Produktivzeitraums zu erfassen; und
- eine Auswerteeinrichtung (A), dazu eingerichtet,
- einen Referenzdatensatz aus dem Referenzsignal und einen Produktivdatensatz aus dem akustischen Signal zu erzeugen;
- eine Regressionsanalyse des Referenzdatensatzes durchzuführen und damit ein Modell zur Beschreibung des akustischen Referenzsignals durch die Betriebsgrößen zu erstellen;
- eine Zustandsbewertung des Betriebsmittels (TR) aus einer Abweichung zwischen dem Produktivdatensatz und gemäß dem Modell modellierten Werten zu erzeugen, **dadurch gekennzeichnet, dass**
- die zeitlich veränderlichen Betriebsgrößen des Betriebsmittels (TR) eine Stufenschalterstellung des Betriebsmittels (TR) oder eines Referenzbetriebsmittels umfassen.

2. System nach Anspruch 1, wobei die Messeinrichtung (M) zum Erfassen des akustischen Signals einen Schallwandler (SW) oder einen Beschleunigungssensor umfasst, welcher am Betriebsmittel (TR) oder im Inneren des Betriebsmittels (TR) oder an einem Aktivteil des Betriebsmittels (TR) angeordnet ist.

3. System nach einem der Ansprüche 1 oder 2, wobei die Messeinrichtung (M) zum Erfassen der Betriebsgrößen wenigstens einen Sensor (UE) und/oder wenigstens eine Überwachungseinrichtung umfasst.

4. Induktives Betriebsmittel umfassend ein System zur Zustandsanalyse gemäß einem 2018P00005 WE
der Ansprüche 1 bis 3.

5. Verfahren zur Zustandsanalyse eines induktiven Betriebsmittels, das als Transformator oder Drossel ausgebildet ist, das Verfahren umfassend:
- Erfassen eines akustischen Referenzsignals und einer Mehrzahl zeitlich veränderlicher Betriebsgrößen des Betriebsmittels (TR) oder eines Referenzbetriebsmittels während eines Referenzzeitraums;
- Erzeugen eines Referenzdatensatzes aus dem Referenzsignal;
- Erstellen eines Modells zur Beschreibung des akustischen Referenzsignals durch die Betriebsgrößen, wobei das Erstellen des Modells eine Regressionsanalyse des Referenzdatensatzes umfasst;
- Erfassen eines akustischen Signals und der Betriebsgrößen während eines Produktivzeitraums und Erzeugen eines Produktivdatensatzes aus dem akustischen Signal;
- Erzeugen einer Zustandsbewertung des Betriebsmittels (TR) aus einer Abweichung zwischen dem Produktivdatensatz und gemäß dem Modell modellierten Werten, **dadurch gekennzeichnet, dass** die zeitlich veränderlichen Betriebsgrößen des Betriebsmittels (TR) eine Stufenschalterstellung des Betriebsmittels oder eines Referenzbetriebsmittels umfassen.

6. Verfahren nach Anspruch 5, außerdem umfassend Vorschlagen, Einleiten und/oder Vornehmen, insbesondere automatisches Einleiten und/oder Vornehmen, einer Handlung an dem Betriebsmittel (TR) in Abhängigkeit von einem Ergebnis der Zustandsbewertung.

7. Verfahren nach einem der Ansprüche 5 oder 6, außerdem umfassend
- Erfassen mindestens eines weiteren akustischen Signals und der Betriebsgrößen während mindestens eines weiteren jeweiligen Produktivzeitraums;
- Erzeugen mindestens eines weiteren Produktivdatensatzes aus dem mindestens einen weiteren akustischen Signal; und
- Erzeugen mindestens einer weiteren Zustandsbewertung des Betriebsmittels (TR) aus jeweiligen Abweichungen zwischen dem mindestens einen weiteren Produktivdatensatz und gemäß dem Modell modellierten Werten.

8. Verfahren nach Anspruch 7, außerdem umfassend
- Aktualisieren des Referenzdatensatzes auf Grundlage des Produktivdatensatzes und/oder des mindestens einen weiteren Produktivdatensatzes; und 2018P00005 WE
- Aktualisieren des Modells mittels Regressionsanalyse des aktualisierten Referenzdatensatzes.

9. Verfahren nach einem der Ansprüche 5 bis 8, wobei das Erfassen des akustischen Signals mittels eines Schallwandlers (SW) oder eines Beschleunigungssensors erfolgt, welcher am Betriebsmittel (TR) oder im Inneren des Betriebsmittels (TR) oder an einem Aktivteil des Betriebsmittels (TR) angeordnet ist.

10. Verfahren nach einem der Ansprüche 5 bis 9, wobei das Erzeugen des Produktivdatensatzes die Bestimmung eines charakteristischen Datensatzes umfasst, welcher dem zeitlichen Verlauf der Amplitude eines vorbestimmten Frequenzanteils des akustischen Signals entspricht.

11. Verfahren nach einem der Ansprüche 5 bis 10, wobei das Erfassen der Betriebsgrö-ßen mittels wenigstens eines Sensors (UE) und/oder wenigstens einer Überwachungseinrichtung erfolgt.

12. Verfahren nach einem der Ansprüche 5 bis 11, wobei die Betriebsgrößen zusätzlich wenigstens eine der folgenden Größen des Betriebsmittels (TR) oder des Referenzbetriebsmittels umfassen:
- Isoliermitteltemperatur;
- Hot-Spot Temperatur;
- Wicklungstemperatur;
- Umgebungstemperatur;
- Laststrom;
- Betriebsspannung;

13. Verfahren nach einem der Ansprüche 5 bis 12, wobei die Regressionsanalyse eine lineare Regressionsanalyse umfasst.

## Claims

1. System for analysis of the state of inductive operating means, the system comprising
- a measuring device (M) constructed for the purpose of
- detecting an acoustic reference signal and a plurality of operating variables, which can change over time, of the operating means (TR) or a reference operating means during a reference time period; and
- detecting an acoustic signal and the operating variables during a productive time period; and
- an evaluating device (A) arranged for the purpose of
- generating a reference data set from the reference signal and a productive data set from the acoustic signal;
- performing a regression analysis of the reference data set and thereby creating a model for description of the acoustic reference signal by the operating variables;
- generating a state evaluation of the operating means (TR) from a difference between the productive data set and values modelled in accordance with the model,
**characterized, in that**
- the time-variable operating variables of the operating means (TR) comprise a tapchanger setting of the operating means (TR) or of a reference operating means.

2. System according to claim 1, wherein the measuring device (M) for detection of the acoustic signal comprises a sound transducer (SW) or an acceleration sensor, which is arranged at the operating means (TR) or in the interior of the operating means (TR) or at an active part of the operating means (TR).

3. System according to one of claims 1 and 2, wherein the measuring device (M) for detection of the operating variables comprises at least one sensor (UE) and/or at least one monitoring device.

4. Inductive operating means comprising a system for state analysis in accordance with any one of claims 1 to 3.

5. Method for analysis of the state of inductive operating means, the method comprising:
- detecting an acoustic reference signal and a plurality of operating variables, which can change over time, of the operating means (TR) or a reference operating means during a reference time period;
- generating a reference data set from the reference signal;
- creating a model for description of the acoustic reference signal by the operating variables, wherein the creation of the model comprises regression analysis of the reference data sets;
- detecting an acoustic signal and the operating variables during a productive time period and generating a productive data set from the acoustic signal;
- generating a state evaluation of the operating means (TR) from a difference between the productive data set and values modelled in accordance with the model,
**characterized in, that**
- the time-variable operating variables of the operating means (TR) comprise a tapchanger setting of the operating means (TR) or of a reference operating means.

6. Method according to claim 5, additionally comprising proposal, introduction and/or undertaking, particularly automatic introduction and/or undertaking, of an action at the operating means (TR) in dependence on a result of the state evaluation.

7. Method according to one of claims 5 and 6, additionally comprising
- detecting at least one further acoustic signal and the operating variables during at least one further respective productive time period;
- generating at least one further productive data set from the at least one further acoustic signal; and
- generating at least one further state evaluation of the operating means (TR) from differences between the at least one further productive data set and values modelled in accordance with the model.

8. Method according to claim 7, additionally comprising
- updating the reference data set on the basis of the productive data set and/or the at least one further productive data set; and
- updating the model by means of regression analysis of the updated reference data set.

9. Method according to any one of claims 5 to 8, wherein the detection of the acoustic signal is carried out by means of a sound transducer (SW) or an acceleration sensor, which is arranged at the operating means (TR) or in the interior of the operating means (TR) or at an active part of the operating means (TR).

10. Method according to any one of claims 5 to 9, wherein the generation of the productive data set comprises determination of a characteristic data set which corresponds with the course over time of the amplitude of a predetermined frequency component of the acoustic signal.

11. Method according to any one of claims 5 to 10, wherein the detection of the operating variables is carried out by means of at least one sensor (UE) and/or at least one monitoring device.

12. Method according to any one of claims 5 to 11, wherein the operating variables comprise at least one of the following variables of the operating means (TR) or the reference operating means:
- insulating means temperature;
- hot-spot temperature;
- winding temperature;
- ambient temperature;
- load current;
- operating voltage;

13. Method according to any one of claims 5 to 12, wherein the regression analysis comprises a linear regression analysis.

## Revendications

1. Système d'analyse de l'état d'un équipement à induction réalisé sous la forme d'un transformateur ou d'une inductance, le système comprenant
- un dispositif de mesure (M), conçu pour
- détecter un signal de référence acoustique et une pluralité de grandeurs de fonctionnement variables dans le temps de l'équipement (TR) ou d'un équipement de référence pendant une période de référence ; et
- détecter un signal acoustique et les grandeurs de fonctionnement pendant une période productive ; et
- un dispositif d'évaluation (A), conçu pour
- générer un jeu de données de référence à partir du signal de référence et un jeu de données productives à partir du signal acoustique ;
- mettre en œuvre une analyse de régression du jeu de données de référence et créer ainsi un modèle de description du signal de référence acoustique au moyen des grandeurs de fonctionnement ;
- générer une évaluation de l'état de l'équipement (TR) à partir d'un écart entre le jeu de données productives et de valeurs modélisées conformément au modèle, **caractérisé en ce que**
- les grandeurs de fonctionnement variables dans le temps de l'équipement (TR) comprennent un réglage du changeur de prise de l'équipement (TR) ou d'un équipement de référence.

2. Système selon la revendication 1, dans lequel le dispositif de mesure (M) destiné à détecter le signal acoustique comprend un transducteur acoustique (SW) ou un capteur d'accélération qui est agencé sur l'équipement (TR) ou à l'intérieur de l'équipement (TR) ou sur une partie active de l'équipement (TR).

3. Système selon l'une quelconque des revendications 1 ou 2, dans lequel le dispositif de mesure (M) destiné à détecter les grandeurs de fonctionnement comprend au moins un capteur (UE) et/ou au moins un dispositif de surveillance.

4. Équipement inductif comprenant un système d'analyse d'état selon l'une quelconque des revendications 1 à 3.

5. Procédé d'analyse de l'état d'un équipement inductif réalisé sous la forme d'un transformateur ou d'une inductance, le procédé comprenant :
- la détection d'un signal de référence acoustique et d'une pluralité de grandeurs de fonctionnement variables dans le temps de l'équipement (TR) ou d'un équipement de référence pendant une période de référence ;
- la génération d'un jeu de données de référence à partir du signal de référence ;
- la création d'un modèle de description du signal de référence acoustique au moyen des grandeurs de fonctionnement, la création du modèle comprenant une analyse de régression du jeu de données de référence ;
- la détection d'un signal acoustique et des grandeurs de fonctionnement pendant une période productive et la génération d'un jeu de données productives à partir du signal acoustique ;
- la génération d'une évaluation de l'état de l'équipement (TR) à partir d'un écart entre le jeu de données productives et de valeurs modélisées conformément au modèle,
**caractérisé en ce que**
les grandeurs de fonctionnement variables dans le temps de l'équipement (TR) comprennent un réglage du changeur de prise de l'équipement ou d'un équipement de référence.

6. Procédé selon la revendication 5, comprenant en outre la proposition, le déclenchement et/ou l'exécution, notamment le déclenchement et/ou l'exécution automatique, d'une action sur l'équipement (TR) en fonction d'un résultat de l'évaluation de l'état.

7. Procédé selon l'une quelconque des revendications 5 ou 6, comprenant en outre
- la détection d'au moins un autre signal acoustique et des grandeurs de fonctionnement pendant au moins une autre période productive respective ;
- la génération d'au moins un autre jeu de données productives à partir dudit au moins un autre signal acoustique ; et
- la génération d'au moins une autre évaluation de l'état de l'équipement (TR) à partir d'écarts respectifs entre ledit au moins un autre jeu de données productives et de valeurs modélisées conformément au modèle.

8. Procédé selon la revendication 7, comprenant en outre
- l'actualisation du jeu de données de référence sur la base du jeu de données productives et/ou dudit au moins un autre jeu de données productives ; et
- l'actualisation du modèle au moyen d'une analyse de régression du jeu de données de référence actualisé.

9. Procédé selon l'une quelconque des revendications 5 à 8, dans lequel la détection du signal acoustique est effectuée au moyen d'un transducteur acoustique (SW) ou d'un capteur d'accélération qui est agencé sur l'équipement (TR) ou à l'intérieur de l'équipement (TR) ou sur une partie active de l'équipement (TR).

10. Procédé selon l'une quelconque des revendications 5 à 9, dans lequel la génération du jeu de données productives comprend la détermination d'un jeu de données caractéristiques qui correspond à l'évolution dans le temps de l'amplitude d'une composante de fréquence prédéterminée du signal acoustique.

11. Procédé selon l'une quelconque des revendications 5 à 10, dans lequel la détection des grandeurs de fonctionnement est effectuée au moyen d'au moins un capteur (UE) et/ou d'au moins un dispositif de surveillance.

12. Procédé selon l'une quelconque des revendications 5 à 11, dans lequel les grandeurs de fonctionnement comprennent en outre au moins l'une des grandeurs suivantes de l'équipement (TR) ou de l'équipement de référence :
- température de l'isolant ;
- température du point chaud ;
- température du bobinage ;
- température ambiante ;
- courant de charge ;
- tension de fonctionnement.

13. Procédé selon l'une quelconque des revendications 5 à 12, dans lequel l'analyse de régression comprend une analyse de régression linéaire.
